# EUROPÄISCHE PATENTSCHRIFT

(11) **EP 1 075 346 B1**
(45) Veröffentlichungstag und Bekanntmachung des Hinweises auf die Patenterteilung: **17.07.2002**
(21) Anmeldenummer: 99913099.0
(22) Anmeldetag: 02.03.1999
(51) Int. Cl.: B23K 20/00

(54) **VERFAHREN ZUR HERSTELLUNG EINER ELEKTRISCHEN VERBINDUNG**
METHOD FOR PRODUCING AN ELECTRICAL CONNECTION
PROCEDE POUR ETABLIR UNE CONNEXION ELECTRIQUE

(30) Priorität: 04.03.1998 DE 19809081
(43) Veröffentlichungstag der Anmeldung: 14.02.2001
(73) Patentinhaber: ROBERT BOSCH GMBH, 70442 Stuttgart (DE)
(72) Erfinder: WILDNER, Ingolf, D-72760 Reutlingen (DE)
(86) Internationale Anmeldenummer: DE9900556
(87) Internationale Veröffentlichungsnummer: WO9944782

(56) Entgegenhaltungen:
- EP-A- 0 810 293
- DE-A- 2 064 289
- US-A- 5 328 079
- JOSHI ET AL.: "All-ball ultrasonic and thermocompression bonds for interconnections" IBM TECHNICAL DISCLOSURE BULLETIN, Bd. 13, Nr. 6, November 1970 (1970-11), Seite 1624 XP002109902

## Beschreibung

Die Erfindung betrifft ein Verfahren zur Herstellung einer elektrischen Verbindung mit den im Oberbegriff des Anspruchs 1 genannten Merkmalen (siehe z.B. US-A-5 328 079)

### Stand der Technik

Aus dem Dokument US-A-5 328 079 geht ein Verfahren zur Herstellung einer elektrischen Verbindung zwischen einer ersten Kontaktfläche und einer zweiten Kontaktfläche hervor. Die elektrische Verbindung wird mittels einer Drahtbundeinrichtung zwischen den Kontaktflächen in Form eines Kontaktdrahtes hergestellt.

Zum Herstellen einer elektrischen Verbindung zwischen wenigstens zwei Kontaktflächen ist eine Einzeldraht-Kontaktierung, ein sogenanntes Bonden, bekannt. Hierbei werden Einzeldrähte, insbesondere Gold- oder Aluminiumdrähte, mittels einer Drahtbondeinrichtung zwischen den zu kontaktierenden Kontaktflächen angeordnet. Bei dem Bonden wird der Kontaktdraht unter Einwirkung von Druck, Ultraschall und Temperatur mit den Kontaktflächen kontaktiert. Der Verbindungsdraht wird zunächst an seinem freien Ende durch Beaufschlagungmit thermischer Energie zu einer Kugel aufgeschmolzen und dann mit einer Bondkapillare auf die erste Kontaktfläche gedrückt. Hierbei verbindet sich der Kontaktdraht mit der Kontaktfläche durch an der Grenzfläche zwischen der Kontaktfläche und dem Kontaktdraht entstehende atomare Bindungskräfte. Während des Kontaktierens mit der ersten Kontaktfläche verformt sich die zuvor angeschmolzene Kugel zu einem Nagelkopf, einem sogenannten Nailhead. Anschließend wird der Kontaktdraht mittels der Drahtbondeinrichtung zur zweiten Kontaktfläche geführt. Um einem Abreißen des Kontaktdrahtes an der ersten Kontaktstelle entgegenzuwirken, wird der Kontaktdraht hierbei in einem Bogen, einem sogenannten Loop, geführt. Der Kontaktdraht wird mittels der Drahtbondeinrichtung auf die zweite Kontaktfläche, unter erneuter Einwirkung von Druck, Ultraschall und Temperatur, gepreßt. Hierbei erfolgt eine Einschnürung des Kontaktdrahtes, so daß dieser eine Sollbruchstelle ausbildet, an der der Kontaktdraht nach Fortführen der Drahtbondeinrichtung von der zweiten Kontaktfläche reißt. Der Kontaktdraht ist mit der zweiten Kontaktfläche über einen sogenannten Stitch verbunden, wobei wiederum zwischen dem Kontaktdraht und der zweiten Kontaktfläche an der Grenzfläche atomare Bindungskräfte entstehen.

Bei diesem bekannten, sogenannten Ball-Wedge-Bonden (Kugel-Kontaktierung mit der ersten Kontaktfläche [Ball], Stitch-Kontaktierung mit der zweiten Kontaktfläche [Wedge]) besteht eine starke Materialabhängigkeit zwischen dem Kontaktdraht und den Kontaktflächen, damit es zur Ausbildung ausreichend großer atomarer Bindungskräfte an den Grenzflächen kommt. Insbesondere beim Kontaktieren der zweiten Kontaktfläche steht nur eine relativ geringe Flächenanbindung zwischen dem Stitch und der Kontaktfläche zur Verfügung, die insbesondere bei Kontaktflächen aus schlecht bondbaren Materialien zu Fehlkontaktierungen führen kann.

### Vorteile der Erfindung

Das erfindungsgemäße Verfahren mit den im Anspruch 1 genannten Merkmalen bietet demgegenüber den Vorteil, daß die Kontaktsicherheit der Verbindung zwischen dem Kontaktdraht und der zweiten Kontaktfläche wesentlich verbessert ist. Dadurch, daß mittels der Drahtbondeinrichtung vor Kontaktierung der ersten Kontaktfläche auf der zweiten Kontaktfläche eine aus dem Material des Kontaktdrahtes bestehende Kontaktmetallisierung erzeugt wird, steht diese Kontaktmetallisierung für das spätere Kontaktieren des Kontaktdrahtes auf der zweiten Kontaktfläche zur Verfügung. Insbesondere ist hierbei vorteilhaft, daß nunmehr eine Kontaktierung zwischen gleichen Materialien, nämlich dem Material der Kontaktmetallisierung und dem Kontaktdraht, erfolgen kann.

Besonders bevorzugt ist, wenn die Kontaktmetallisierung durch Beaufschlagen des freien Endes des Kontaktdrahtes mit einer thermischen Energie und anschließendem Andrücken des Kontaktdrahtes unter Einwirkung von Ultraschallenergie an die zweite Kontaktfläche erzeugt wird. Hierdurch wird an der zweiten Kontaktfläche eine der späteren Kontaktierung des Kontaktdrahtes dienende Kontaktmetallisierung vorbereitet, die aufgrund ihrer, ansich aus der Ausbildung der Kontaktstelle an der ersten Kontaktfläche bekannten Ausbildung, relativ großflächig an der zweiten Kontaktfläche anliegt. Hierdurch können auch schlecht bondbare Materialien relativ große atomare Bindungskräfte an der Grenzfläche zwischen der zweiten Kontaktfläche und der Kontaktmetallisierung aufbauen, die eine hohe Kontaktsicherheit gewährleisten. Die eigentliche Kontaktierung des Kontaktdrahtes erfolgt dann auf beziehungsweise mit der Kontaktmetallisierung, wobei aufgrund der gleichen Materialien auch bei relativ kleiner Kontaktfläche des anzubondenden Kontaktdrahtes an der Grenzfläche zwischen der Kontaktmetallisierung und des gebondeten Kontaktdrahtes große atomare Bindungskräfte wirken können.

Ferner ist vorteilhaft, daß durch das vorherige Erzeugen der Kontaktmetallisierung beim eigentlichen Kontaktieren des Kontaktdrahtes an der zweiten Kontaktfläche die Drahtbondeinrichtung zum Erzeugen des notwendigen Druckes nicht mehr unmittelbar mit der Oberfläche der Kontaktfläche in Berührung kommt. Diese ist somit weitgehend unempfindlich gegenüber topografischen Einflüssen und Stoffeigenschaften der Kontaktfläche.

Darüber hinaus ist vorteilhaft, daß durch das vorhergehende Aufbringen der Kontaktmetallisierung für das nachfolgende Kontaktieren des Kontaktdrahtes eine metallisch saubere, von Fremdkontaminationen freie Kontaktfläche zur Verfügung steht, so daß eine optimale Anbindung des Kontaktdrahtes möglich ist.

Ferner ist vorteilhaft, dass durch das Kontaktieren des Kontaktdrahtes auf die aus dem gleichen Material bestehende Kontaktmetallisierung dieses Anbinden unter Raumtemperatur, das heißt nicht unter Zufuhr einer zusätzlichen thermischen Energie während des Kontaktierens des Kontaktdrahtes, erfolgen kann, da genügend große atomare Bindungskräfte bereits unter Kontaktdruck bei Raumtemperatur erzielbar sind. Im Bedarfsfall kann selbstverständlich auch eine zusätzliche, ansich nicht notwendige Zufuhr einer thermischen Energie erfolgen.

In weiterer bevorzugter Ausgestaltung der Erfindung ist vorgesehen, dass der Kontaktmetallisierung während derer Aufbringung auf die Kontaktfläche Formmerkmale aufgeprägt werden, die ein nachfolgendes Kontaktieren des Kontaktdrahtes unterstützen. Hierdurch wird vorteilhaft eine formschlüssige Verbindung zwischen dem Kontaktdraht un dder Kontaktmetallisierung möglich, die bereits die elektrische Kontaktierung gestattet. Ein aufzubringender Druck auf die Kontaktstelle über die Drahtbondeinrichtung kann somit auf den Druck begrenzt werden, der zum Erzeugen der Sollbruchstelle des Kontaktdrahtes ausreichend ist. Ein zum Erreichen einer stoffschlüssigen Verbindung (atomare Bindungskräfte) zwischen der Kontaktmetallisierung und dem Kontaktdraht erforderlicher höherer Kontaktdruck kann entfallen, zumindest reduziert werden.

Weitere vorteilhafte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figuren 1a bis 1k: jeweils in schematischen Ansichten die Verfahrensschritte des erfindungsgemäßen Verfahrens und
- Figuren 2a bis 2c: eine vergrößerte Darstellung einer Kontaktstelle.

### Beschreibung der Ausführungsbeispiele

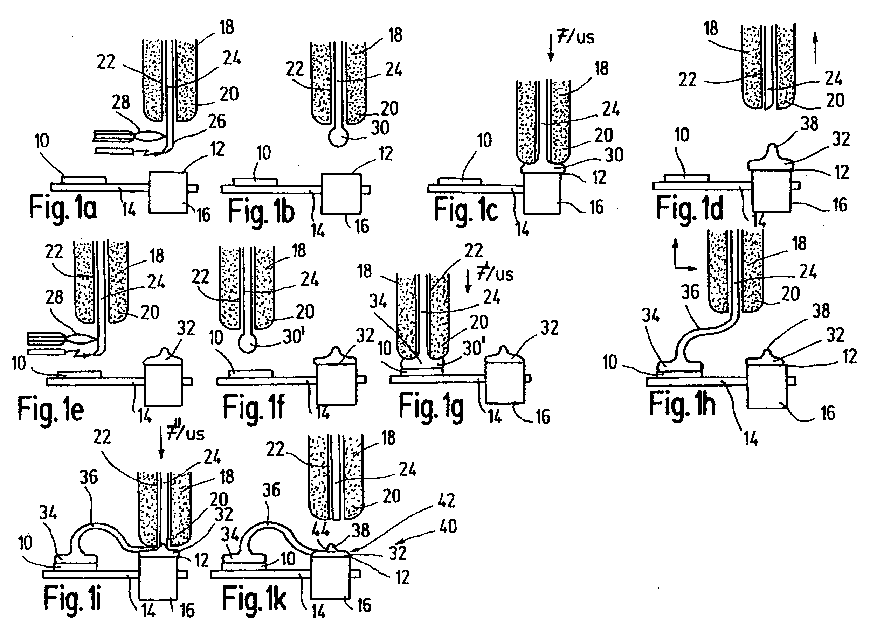

In der Figur 1 ist in einzelnen Phasen ein Verfahren zur Herstellung einer elektrischen Verbindung zwischen einer ersten Kontaktfläche 10 und einer zweiten Kontaktfläche 12 gezeigt. Die Kontaktfläche 10 ist auf einem Substrat 14, beispielsweise einem Mikrochip, angeordnet, während die zweite Kontaktfläche 12 auf einem Substrat 16, beispielsweise einem Gehäuseteil eines Mikrohybridbauelementes, angeordnet ist. Die Kontaktfläche 10 besteht beispielsweise aus einem Goldpad, während die Kontaktfläche 12 beispielsweise aus einem Aluminiumpad besteht.

Die elektrische Verbindung zwischen den Kontaktflächen 10 und 12 wird mittels einer hier lediglich schematisch angedeuteten Drahtbondeinrichtung 18 durchgeführt. Derartige Drahtbondeinrichtungen 18 sind allgemein bekannt, so daß auf deren Aufbau und Funktion im Rahmen der Beschreibung im einzelnen nicht eingegangen werden soll. Die Drahtbondeinrichtung 18 weist ein Kapillarmundstück 20 auf, das eine Drahtführungsöffnung 22 besitzt. Die Drahtführungsöffnung 22 kann hierbei beispielsweise koaxial zu einer Längsachse des Kapillarmundstückes 20 verlaufen. Nach anderen Ausführungsbeispielen kann jedoch die Drahtführungsöffnung 22 auch unter einem Winkel zur Längsachse des Kapillarmundstückes 20 angeordnet sein. Durch die Drahtführungsöffnung 22 ist ein Kontaktdraht 24 geführt. Der Kontaktdraht 24 besteht beispielsweise aus Gold. Mittels einer nicht gezeigten Vorschubeinrichtung ist der Kontaktdraht 24 durch die Durchgangsöffnung 22 dosierbar, so daß nacheinanderfolgend das erläuterte Verfahren zur Herstellung der elektrischen Verbindung zwischen den Kontaktflächen 10 und 12, sowie in entsprechender zeitlicher Abfolge eine Vielzahl derartiger Verbindungen herstellbar sind. Der Kontaktdraht 24 wird hierbei von einem nicht dargestellten Vorrat entnommen.

Anhand der Figuren 1a bis 1k werden die für die Herstellung der elektrisch leitenden Verbindung erforderlichen Verfahrensschritte verdeutlicht. Zunächst wird gemäß Figur 1a die Drahtbondeinrichtung 18 über der zweiten Kontaktfläche 12 positioniert. Ein aus der Drahtführungsöffnung 22 herausragendes freies Ende 26 des Kontaktdrahtes 24 wird mit einer schematisch angedeuteten thermischen Energiequelle 28 über den Schmelzpunkt des Kontaktdrahtes 24 erwärmt. Die thermische Energiequelle 28 kann beispielsweise eine Flamme oder ein elektrischer Funken sein. Infolge einer Oberflächenspannung zieht sich die Schmelze des Kontaktdrahtes 24 zu einer Kugel 30 zusammen. Diese Kugel 30 bildet einen sogenannten Ball. Gemäß dem in Figur 1c verdeutlichten Verfahrensschritt wird anschließend die Drahtbondeinrichtung 18 in Richtung der zweiten Kontaktfläche 12 bewegt, so daß die Kugel 30 plastisch verformt wird. Die Drahtbondeinrichtung 18 wird hierbei mit einer Kraft F und Ultraschall US beaufschlagt. Durch Kraft- und Ultraschalleinwirkung kommt es an der Grenzfläche zwischen der Kontaktfläche 12 und der verformten Kugel 30 zum Entstehen atomarer Bindungskräfte, das heißt einer stoffschlüssigen Verbindung durch Nutzung von Valenzelektroneneffekten oder auch einer formschlüssigen Verbindung oder Kombination aus stoff- und formschlüssiger Verbindung zwischen dem Kontaktdraht 24 und der Kontaktfläche 12. Durch nachfolgendes, in Figur 1d verdeutlichtes, Abheben der Drahtbondeinrichtung 18 von der Kontaktfläche 12 reißt der Kontaktdraht 24 ab, da eine Bindungskraft zwischen der deformierten Kugel 30, nunmehr als Bump 32 bezeichnet, und der Kontaktfläche 12 größer ist als die Reißlast (Breaking load) des Kontaktdrahtes 24.

Während des Reißens wird der Kontaktdraht 24 durch die Drahtführungsöffnung 22 herausgezogen und erneut thermisch erwärmt. Hierdurch kommt es wiederum zur Ausbildung einer Kugel 30' (Figur 1e, Figur 1f). Wie Figur 1g verdeutlicht, wird anschließend die Drahtbondeinrichtung 18 in Richtung der ersten Kontaktfläche 10 bewegt, so daß die Kugel 30' mit der Kontaktfläche 10 in Berührung kommt und mit dieser unter Kraft- und Ultraschalleinwirkung gefügt wird. Hierbei werden entsprechend der Höhe der Kontaktkraft F' und der Ultraschall-Leistung US an der Grenzfläche zwischen der deformierten Kugel 30' und der Kontaktfläche 10 atomare Bindungskräfte aufgebaut.

Auf der Kontaktfläche 10 kommt es hierbei zur Ausbildung eines sogenannten Nailhead 34.

In einem nächsten Verfahrensschritt, gemäß Figur 1h, wird die Drahtbondeinrichtung 18 verlagert, indem diese von der Kontaktfläche 10 sowohl nach oben und seitlich in Richtung der Kontaktfläche 12 bewegt wird. Diese Bewegungen können nacheinander oder überlagernd durchgeführt werden. Der Kontaktdraht 34 wird hierbei lockergelassen, so daß dieser nicht abreißt. Der Kontaktdraht 24 wird unter Ausbildung einer Schleife 36 (Loop) zu der zweiten Kontaktfläche 12 geführt. Anschließend wird die Drahtbondeinrichtung 18 in Richtung der Kontaktfläche 12 bewegt. Hierdurch kommt der Kontaktdraht 24 in Berührungskontakt mit dem Bump 32. Hierbei deformiert das Kapillarenmundstück 20 den Bump 32, der gemäß Figur 1d entsteht. Durch Aufbringen einer Kontaktkraft F" und Ultraschallenergie US wird der Kontaktdraht 24 gemeinsam mit der Spitze 38 des Bump 32 verformt, so daß ein Stoffschluß, zum Beispiel Gold zu Gold, zwischen dem Kontaktdraht 24, nämlich zwischen der Schleife 36 des Kontaktdrahtes 24 und dem Bump 32 entsteht.

Wie Figur 1k verdeutlicht, ist die Schleife 36 nach Abheben der Drahtbondeinrichtung 18 mit dem Bump 32, und über diesen mit der Kontaktfläche 12 kontaktiert. Auf diese Weise ist eine elektrische Verbindung zwischen den Kontaktflächen 10 und 12 hergestellt. Der anhand der Figuren 1a bis 1k erläuterte Verfahrensablauf wiederholt sich fortlaufend, entsprechend der Anzahl der zu kontaktierenden Kontaktflächen. Diese Verfahren sind mittels computergesteuerter Drahtbondeinrichtungen 18 mit hoher Präzision in schneller Abfolge wiederholbar.

Während des Fügens des Kontaktdrahtes 24 mit dem Bump 32 (Figur 1i) wird über das Kapillarmundstück 20 der Kontaktdraht 24 gequetscht, so daß eine Sollbruchstelle entsteht, die beim Abheben des Kapillarmundstückes 20 (Figur 1k) reißt.

Anhand des erläuterten Verfahrensablaufes, insbesondere in den in Figuren 1i und 1k gezeigten Ansichten wird deutlich, daß die Kontaktstelle 40, an der die Verbindung zwischen der Schleife 36 und der Kontaktfläche 12 erfolgt, von einem sandwichartigen Aufbau der Kontaktfläche 12, dem Bump 32 als Kontaktmetallisierung 42 und einem sogenannten Stitch 44 der Schleife 36 erfolgt. Der Stitch 44 besitzt hierbei eine relativ geringe Kontaktfläche mit dem Bump 32, wobei aufgrund der gleichen Materialeigenschaften, da der Bump 32 ebenfalls aus dem Kontaktdraht 24 erzeugt wurde, diese zur Aufrechterhaltung einer relativ großen und damit sicheren Kontaktbindung ausreichend ist. Die Anbindung an die Kontaktfläche 12 des Substrates 16 erfolgt über die Grenzfläche zwischen dem Bump 32 und der Kontaktfläche 12. Diese ist aufgrund der anhand der Figuren 1a bis 1d erläuterten Ausbildung relativ großflächig und gewährleistet somit eine sichere Kontaktierung.

Auf die Ausbildung der geometrischen Ausformung von dem Bump 32 und dem Stitch 44 kann über eine Gestaltung des Kapillarmundstückes 20 (allgemein Bondkapillare) Einfluß genommen werden. Entsprechend der Ausbildung des Mündungsbereiches des Kapillarmundstückes 20 kann hier beispielsweise die Form der Spitze 38 oder auch andere geeignete Formmerkmale (zum Beispiel Dicke und Durchmesser) des Bump 32 erzeugt werden, die in einfacher Weise einen Stoffschluß mit dem Stitch 44 gestatten, aber auch die formschlüssige Anbindung von Bump 32 an die Kontaktfläche 12 beeinflussen. Somit wird die Verbindung zwischen der Schleife 36 und der Kontaktfläche 12 in erster Linie über einen Formschluß zwischen Bump 32 und Kontaktfläche 12 erzielt und erst in zweiter Linie über atomare Bindungskräfte (Stoffschluß) zwischen dem Stitch 44 und dem Bump 32.

Die Erfindung beschränkt sich selbstverständlich nicht auf das dargestellte Ausführungsbeispiel. So sind insbesondere andere konstruktive Gestaltungen der Drahtbondeinrichtung 18 möglich, indem beispielsweise die Ausbildung der Kapillare, die die Verformung des Bump 32 und/oder des Stitches 44 vornimmt, konstruktiv von der Zuführung des Kontaktdrahtes 24 getrennt ist. Hierdurch wird unabhängig von der Zuführung des Kontaktdrahtes 24 eine Ausbildung des Formschlusses zwischen dem Stitch 44 und dem Bump 32 optimierbar.

Insgesamt ist mit einfachen Verfahrensschritten ein sogenanntes Ball-Wedge-Verbindungsverfahren realisierbar, wobei durch die erfindungsgemäße Ausgestaltung des Verfahrens ein sogenanntes Ball-Ball (Wedge)-Verbindungsverfahren realisiert ist.

Die für die Zuverlässigkeit bei herkömmlichen Ball-Wedge-Verfahren erforderliche thermische Energie (Aufheizen der Kontaktflächen 10 und 12 beziehungsweise der Substrate 14 und 16) ist durch das erfindungsgemäße Verfahren nicht zwingend erforderlich. Die Universalität des Verfahrens wird dadurch deutlich, denn so können auch thermisch empfindliche beziehungsweise konstruktiv bedingt nicht aufheizbare Kontakte in Bauteilen, Geräten und dergleichen mit den erfindungsgemäßen Verfahren verbunden werden.

Durch geeignete Wahl von Kontaktkraft F und Ultraschallenergie US können im Verfahrensschritt gemäß Figur 1c empfindliche Kontaktflächen 12 kontaktiert werden (geringere Flächenpressung, als es mit der direkten Stitch- oder Wedge-Kontaktierung möglich wäre). Durch die verfahrensbedingte erhöhte Ausbildung der Kontakte Bump 32 und Wedge ergibt sich die Möglichkeit in Kavitäten zu kontaktieren, die für das herkömmliche Verfahren aufgrund der Kapillarenabmessungen nicht möglich sind.

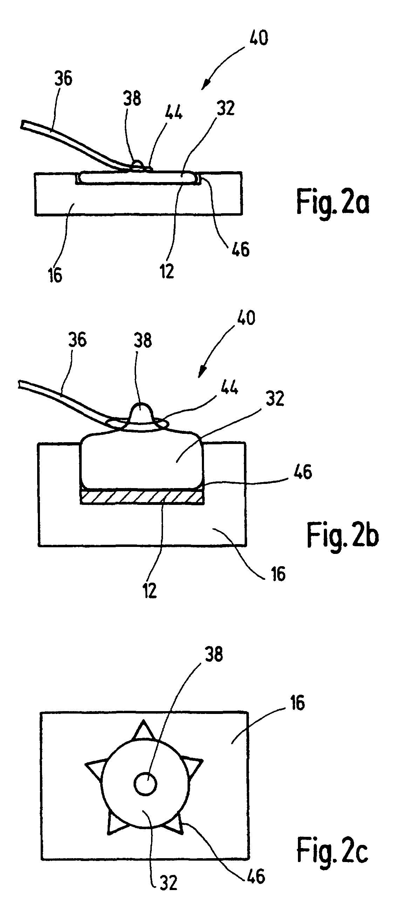

Anhand einer vergrößerten Darstellung der Kontaktstelle 40 in den Figuren 2a bis 2c wird eine formschlüssige Verbindung zwischen dem Bump 32 und der Kontaktfläche 12 des Substrates 16 verdeutlicht. Hierbei ist in dem Substrat 16 eine Kavität 46 angedeutet, die quasi eine Vertiefung im Substrat 16 bildet. Die Form der Kavität 46 ist hierbei frei wählbar und vorzugsweise einer Form eines erzeugbaren Bump 38 anpaßbar. Wie die schematische Draufsicht in Figur 2c zeigt, kann die Kavität 46 eine unregelmäßige Form aufweisen. Hierdurch wird ein verbesserter Formschluß zwischen dem Bump 38 und der Kontaktfläche 12 des Substrates 16 möglich. Dieser verbesserte Formschluß wiederum gestattet eine effektivere, insbesondere sichere Anbindung zwischen dem Bump 38 und dem Substrat 16, auch wenn diese aufgrund der gegebenen Materialeigenschaften ansich nicht beziehungsweise nur sehr schlecht bondbar sind. Bei entsprechender Ausbildung der Kavität 46 kann auf eine stoffschlüssige Verbindung zwischen dem Bump 38 und der Kontaktfläche 12 gegebenenfalls vollständig verzichtet werden. Eine stoffschlüssige Verbindung kann dann auf das Kontaktieren des Stitches 44 mit dem Bump 32 beschränkt sein.

## Patentansprüche

1. Verfahren zur Herstellung einer elektrischen Verbindung zwischen einer ersten Kontaktfläche (10) und einer zweiten Kontaktfläche (12), wobei mittels einer Drahtbondeinrichtung (18) zwischen den Kontaktflächen (10, 12) ein Kontaktdraht (24) angeordnet wird, indem der Kontaktdraht (24) zunächst mit der ersten Kontaktfläche (10) und anschließend mit der zweiten Kontaktfläche (12) kontaktiert wird und anschließend durch die Drahtbondeinrichtung (18) abgetrennt wird, wobei mittels der Drahtbondeinrichtung (18) vor Kontaktierung der Kontaktflächen (10, 12) auf mindestens einer Kontaktfläche (12) eine aus dem Material des Kontaktdrahtes (24) bestehende Kontaktmetallisierung (42) erzeugt wird, indem zunächst durch Beaufschlagung eines freien Endes (26) des Kontaktdrahtes (24) mit einer thermischen Energie dieses Ende zu einer Kugel aufgeschmolzen wird, **dadurch gekennzeichnet, daß** anschließend ein derartiges Andrücken der Kugel an die mindestens eine Kontaktfläche (12) erfolgt, daß die Kugel plastisch verformt wird und eine Verbindung zwischen der plattgedrückten Kugel und der mindestens einen Kontaktfläche in erster Linie über einen Formschluß erzielt werden kann.

2. Verfahren nach einem der vorhergehenden Ansprüche, **dadurch gekennzeichnet, daß** das Andrücken der Kugel in einer Kavität (46) der mindestens einen Kontaktfläche (12) erfolgt.

3. Verfahren nach Anspruch 1 oder 2, **dadurch gekennzeichnet, daß** der Kontaktmetallisierung (42) durch die Drahtbondeinrichtung (18) Formmerkmale aufgeprägt werden, die der Erzielung eines Stoffschlusses mit einem Stich (44) des Kontaktdrahtes (24) dienen und die formschlüssige Anbindung der Kontaktmetallisierung an die mindestens eine Kontaktfläche (12) unterstützen.

4. Verfahren nach einem der vorhergehenden Ansprüche, **dadurch gekennzeichnet, daß** die mindestens eine Kontaktfläche lediglich durch die der Kugel innewohnende thermische Energie erwärmt wird.

5. Verfahren nach einem der vorhergehenden Ansprüche, **dadurch gekennzeichnet, daß** der Kontaktdraht (24) unter einer Aufbringung einer Kontaktkraft (F") und einer Ultraschallenergie (US) durch die Drahtbondeinrichtung (18) auf die Kontaktmetallisierung (42) gedrückt wird, wobei die Kontaktkraft (F'') und die Ultraschallenergie so gewählt ist, daß am Kontaktdraht eine Sollbruchstelle ausgebildet wird, an der der Kontaktdraht (24) nach Abheben der Drahtbondeinrichtung (18) reißt.

## Claims

1. Method for producing an electrical connection between a first contact area (10) and a second contact area (12), a contact wire (24) being arranged between the contact areas (10, 12) by means of a wire-bonding device (18), in that the contact wire (24) is initially bonded to the first contact area (10) and subsequently bonded to the second contact area (12) and is subsequently severed by the wire-bonding device (18), a contact metallization (42), consisting of the material of the contact wire (24), being produced on at least one contact area (12) by means of the wire-bonding device (18) before bonding of the contact areas (10, 12), in that firstly, by exposing a free end (26) of the contact wire (24) to a thermal energy, this end is melted to form a ball, **characterized in that** subsequently the ball is pressed onto the at least one contact area (12) in such a way that the ball is plastically deformed and a connection can be achieved between the pressed-flat ball and the at least one contact area, primarily by means of a positive engagement.

2. Method according to one of the preceding claims, **characterized in that** the ball is pressed onto the at least one contact area (12) in a cavity (46) of the latter.

3. Method according to Claim 1 or 2, **characterized in that** the contact metallization (42) has impressed into it by the wire-bonding device (18) geometrical characteristics which serve for achieving an integral engagement with a bow (44) of the contact wire (24) and support the positive engagement of the contact metallization to the at least one contact area (12).

4. Method according to one of the preceding claims, **characterized in that** the at least one contact area is heated only by the thermal energy inherent in the ball.

5. Method according to one of the preceding claims, **characterized in that** the contact wire (24) is pressed onto the contact metallization (42) by applying a contact force (F'') and an ultrasonic energy (US), the contact force (F'') and the ultrasonic energy being chosen such that a predetermined breaking point is formed on the contact wire, at which point the contact wire (24) ruptures after the wire-bonding device (18) is lifted off.

## Revendications

1. Procédé pour réaliser une connexion électrique entre une première surface de contact (10) et une seconde surface de contact (12), selon lequel
à l'aide d'une installation de liaison par fil (18) on installe un fil de contact (24) entre les surfaces de contact (10, 12) en mettant tout d'abord en contact le fil de contact (24) avec la première surface de contact (10) puis avec la seconde surface de contact (12) et ensuite en séparant à l'aide de l'installation de liaison par fil (18),
à l'aide de l'installation de liaison par fil (18), avant de réaliser le contact des surfaces de contact (10, 12), sur au moins une surface de contact (12) on réalise une métallisation de contact (42) dans la matière du fil de contact (24) en ce qu'en appliquant l'extrémité libre (26) du fil de contact (24) et une énergie thermique appropriée, on fait fondre cette extrémité pour former une bille,
**caractérisé en ce qu'**
ensuite on presse la bille contre au moins une surface de contact (12), on déforme la bille plastiquement et on réalise une liaison entre la bille aplatie et au moins une surface de contact, en première ligne par une liaison par la forme.

2. Procédé selon la revendication 1,
**caractérisé en ce qu'**
on presse la bille dans une cavité (46) d'au moins une surface de contact (12).

3. Procédé selon la revendication 1,
**caractérisé en ce qu'**
on imprime la métallisation de contact (42) en lui donnant des caractéristiques de forme à l'aide de l'installation de liaison par fil (18), ces caractéristiques servant à réaliser une liaison de matière avec une extrémité (44) du fil de contact (24) et on renforce la liaison par la forme de la métallisation de contact sur au moins une surface de contact (12).

4. Procédé selon l'une des revendications précédentes,
**caractérisé en ce qu'**
on chauffe au moins une surface de contact uniquement par l'énergie thermique propre à la bille.

5. Procédé selon l'une des revendications précédentes,
**caractérisé en ce qu'**
on presse le fil de contact (24) en appliquant une force de contact (F") et de l'énergie d'ultrasons (US) avec l'installation de liaison par fil (18) sur la métallisation de contact (42), en choisissant la force de contact (F") et l'énergie de l'ultrason pour former un point de rupture de consigne sur le fil de contact qui se déchire lorsqu'on soulève l'installation de liaison par fil (18).
